Europäisches Patentamt

European Patent Office

Office européen des brevets

(11) Publication number: **0 471 471 A1**

# EUROPEAN PATENT APPLICATION

(21) Application number: **91306984.5**

(22) Date of filing: **30.07.91**

(51) Int. Cl.5: **H01L 23/495**

(30) Priority: **15.08.90 US 570109**

(43) Date of publication of application:
**19.02.92 Bulletin 92/08**

(84) Designated Contracting States:
**DE FR GB**

(71) Applicant: **International Business Machines Corporation**
**Old Orchard Road**
**Armonk, N.Y. 10504(US)**

(72) Inventor: **Singh, Shanker**
**990 E Camino Alberca**
**Tucson, Arizona 85718(US)**

(74) Representative: **Atchley, Martin John Waldegrave et al**
**IBM United Kingdom Limited Intellectual Property Department Hursley Park**
**Winchester Hampshire SO21 2JN(GB)**

(54) **Package enclosing semiconductor devices.**

(57) The present invention relates to a package enclosing at least one semiconductor device (8, 10) comprising an enclosure (2) enclosing the semiconductor device and having six generally rectangular faces, two of which have relatively large areas and the rest of which have relatively small areas and form edge faces, and a plurality of connecting leads (4, 6) connected to the semiconductor device and extending side by side generally in a line from one of the edge faces.

According to the invention the package is characterised in that adjacent ones of the connecting leads project from the edge face in opposite directions.

FIG.1

This invention relates generally to the field of semiconductor device packages and more particularly to the design of the connecting leads for connecting such packages to external circuits.

Integrated circuits or semiconductor devices are generally housed in plastic or ceramic packages. These packages provide protection from physical damage, provide enhanced heat dissipation, and further provide connections from the integrated circuits or semiconductor devices to external leads on the packages themselves. The external leads may then be soldered or connected to a Printed Circuit Board (PCB) or other apparatus while the device housed in the package remains protected. The number of semiconductor devices integrated on a single integrated circuit has increased steadily with improvements in semiconductor technology. Generally, the number of external leads required per integrated circuit increase as the number of semiconductor devices per integrated circuit increases. The package size is often determined by the number of external leads required. As a result, as more external leads are required the package size increases accordingly.

Packages usually have six generally rectangular faces with two of the opposite faces being larger in area than the other faces. The smaller faces are sometimes called the "edge faces".

The integrated circuit or semiconductor device package may be attached to the PCB using one of several techniques. One popular technique is Pin Through Hole (PTH) technique wherein the connection leads or pins from the package are inserted through predefined holes in the PCB from one side of the PCB and are soldered to the wiring traces (conductors) on the opposite side of the PCB. This method of attachment has the advantages of being highly automated, providing strong connections, and being easily inspected and tested. A disadvantage of the PTH technique is that the distance between adjacent external leads is presently limited to approximately 100 mils (2.5 mm) in order to allow for the use of automatic insertion tools. There are some non-standard components having distances between adjacent leads less than 100 mils (2.5 mn), but more sophisticated and specialised tools are required. Furthermore, the speed of assembly is decreased as compared to packages having lead distances of 100 mils (2.5 mm).

Several packages are presently available which use the PTH attachment technique. Dual In-line Packages (DIP) have a row of external leads on opposite edge faces of the package wherein the package is mounted flat on the PCB. DIPs are very common for integrated circuits requiring a relatively low number of connecting leads or pins, i.e., 64 external leads or less. DIPs are limited to the relatively low count number of external connecting leads applications because of the increased size of the package as a result of both the number of external connecting leads and the 100 mil (2.5 mm) pitch between adjacent leads requirement.

The number of external connecting leads may be further increased for a given package size using the PTH technique by using a Pin Grid Array (PGA) package. The external connecting leads or pins on a PGA package protrude from the bottom (large area face) of the package. A 100 mil (2.5 mm) pitch between adjacent pins is still required for industry standard tools and assembly processes, but more pins can be provided over the bottom surface of the package. This packaging technology (PGA) is useful for semiconductor packages requiring over 100 external connecting leads. PGA technology as used with the PTH attachment techniques has other drawbacks, however, because the holes going through the PCB reduce the density of the wiring traces (conductors), especially in PCBs using a plurality of layers of wiring traces.

The wiring trace density and the distance limitation between external connecting leads are both improved upon by using Surface Mount Technology (SMT). The external connecting leads of SMT packages are attached to wiring traces on the top surface of the PCB thus removing the requirement of providing holes in the PCB which further improves the density of the wiring traces in multilayer PCBs. The distance limitation of 100 mils (2.5 mm) between external leads is reduced to approximately 50 mils (1.25 mm) due to the different requirements of the automatic attachment tools. A chip carrier package is an example of a package that is used in SMT. The chip carrier package is typically a flat package with two square larger faces and having external leads protruding from all four edges of the package, the external leads generally being spaced at a 50 mil (1.25 mm) pitch. As a result, chip carriers are useful for applications requiring external connecting leads in excess of 200.

A resin-moulded package for integrated circuits having external leads on all four edge faces of the package is described in US -A-4,698,660. Grooves are provided on the bottom face of the package so that each external lead may be bent under the package with the tip resting in a corresponding groove. The external leads of the package may then be attached to the PCB with the package itself not touching the PCB (standoff distance) which improves the heat dissipation of the package. A higher external lead density is achieved in the plastic surface mounted package described in US -A-4,463,217. This patent describes putting two rows of pins on each of the four edge faces of the package with the first of the two rows of external leads being placed in notches between the second of the two rows of external leads. Adjacent external leads in each single row are separated by 50 mils (1.25 mm) but the distance between adjacent leads in the first row and the second row is only 25 mils (0.625 mm).

Packaging semiconductor memories poses additional problems. Memories are typically packaged in plastic DIPs (Dual In-Line Packages) and mounted using the PTH technique in order to minimise the costs. The number of bits or memory cells that can be integrated on a single circuit is continually expanding as transistor feature sizes continue to shrink. However, with each new generation of memory, i.e., from 4 Megabits to 16 Megabits (millions of bits per circuit), at least two additional external leads are required. Not only are the number of bits per memory chip increasing, but so also are the number of memory chips that can be put on a single PCB, not uncommonly 246 Megabytes on a single board. In order to increase the number of such chips per board it is beneficial to mount the package on its edge face where the external leads protrude from the edge face of the package thereby reducing the surface area of the PCB required per package. The distance between leads, however, is still limited to a distance which cannot economically accommodate future memory devices.

With each new generation of memories and thus an additional external lead, the length of the package must be increased by another 50 mils (1.25 mm) resulting in a package size that is controlled by the number of external leads. The edge connected packages are unable to benefit from having external leads on all sides of the package or from having two rows per side. Therefore, future larger memory devices would need to use an alternative and more expensive form of packaging, such as the chip carrier which further reduces the memory density on a PCB.

The object of the present invention is to provide an improved package enclosing semiconductor devices.

The present invention relates to a package enclosing at least one semiconductor device comprising an enclosure enclosing the semiconductor device and having six generally rectangular faces, two of which have relatively large areas and the rest of which have relatively small areas and form edge faces, and a plurality of connecting leads connected to the semiconductor device and extending side by side generally in a line from one of the edge faces.

According to the invention the package is characterised in that adjacent ones of the connecting leads project from the edge face in opposite directions.

According to one embodiment of the invention a surface mounted edge connected semiconductor device package for enclosing at least one semiconductor device includes an enclosure having a top and a bottom and first and second substantially parallel lateral surfaces. A plurality of external leads for contacting the at least one semiconductor device extend from the bottom of the semiconductor device package. The plurality of external leads are spaced at a predetermined distance from each other wherein every other external lead of the plurality of external leads is bent in a direction opposite of the direction in which the other leads of the plurality of external leads are bent. As a result, the external leads may be spaced coming out of the bottom of the package at a pitch that is half of what current automated package attaching tools are capable of handling.

In order that the invention may be more readily understood two embodiments will now be described with reference to the accompanying drawings, in which:

FIG. 1 is a perspective view of a surface mounted edge connected semiconductor device package according to the present invention, and

FIG. 2 is a perspective view of another surface mounted semiconductor device package having gullwing leads according to the present invention.

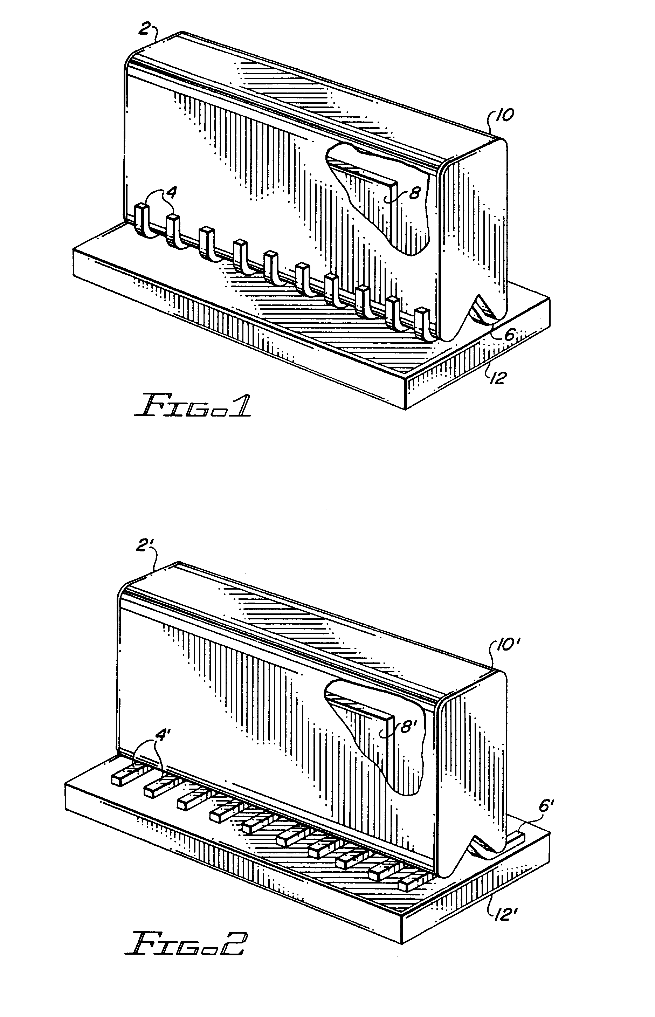

FIG. 1 is a perspective view of a package 2 having a plurality of external leads 4 and 6 which are of the type known as Small Outline J-leads (SOJ leads). FIG. 2 is a perspective view of a package 2' having a plurality of leads 4' and 6' of the gullwing type. Features of the package 2' of FIG. 2 are represented by primed reference numbers of those used in FIG. 1 for the same or similar features.

The package 2 is shown with one of the smaller edge faces attached to a Printed Circuit Board (PCB) 12 and is therefore called an edge connected package. The plurality of external SOJ leads 4 and 6 protrude from the centre of the bottom edge of the edge connected package 2. While the bottom edge of the edge connected package 2 is shown having a V shape recess it can be appreciated that this is not meant to be limiting as the bottom edge can take other shapes. For example, the bottom edge could be flat. All the external SOJ leads 4 are bent over to the left as viewed in the Figures and all the external SOJ leads 6 are bent over to the right such that adjacent external SOJ leads of the plurality of external SOJ leads 4 and 6 are bent in opposite directions.

The plurality of external SOJ leads 4 and 6 are spaced apart at a predetermined distance, for example, 25 mils (0.625 mm). Therefore, adjacent external leads 4 are spaced apart by 50 mils (1.25 mm) and adjacent external SOJ leads 6 likewise are spaced apart by 50 mil (1.25 mm). The advantage of this technique is that twice as many external leads can be provided for on an edge connected package while still taking advantage of currently used automated package attachment tools that require a predetermined distance between external leads, for example, a distance of 50 mils (1.25 mm). SOJ leads are typically attached to the PCB 12 by vapour phase soldering techniques. As a result, memory circuits having increased number of bits and hence increased number of external leads may be packaged in the edge connected package 2.

Furthermore, it is also possible to put more than one memory chip in a single edge connected package 2 since there are now enough external leads of the plurality of external SOJ leads 4 and 6 to accommodate both memory chips. Also because the edge connected package 2 only has a single edge facing the PCB 12, two larger faces are available to accommodate a memory circuit on each face while still providing adequate heat dissipation.

A memory circuit 8 is shown attached to one of the larger surfaces or faces of the edge connected package 2 while a memory circuit 10 (not clearly illustrated) is connected to another of the larger surfaces or faces of the edge connected package 2. While the preferred embodiment is shown enclosing memory circuits it can be appreciated that other types of circuits can be enclosed as well or alternatively, for example logic circuits. The external SOJ leads 4 and 6 are electrically connected to the memory circuits 8 and 10. A single one of the external SOJ leads 4 can be connected to the memory circuit 8 while another single one of the plurality of external SOJ leads 6 can be connected to the memory circuit 10, each for the purpose of selecting the respective memory circuit 8 or 10 (i.e., take out of standby mode). By making only one of the memory circuits 8 or 10 active at a time the power dissipation of the edge connected package 2 is reduced.

The edge connected package 2' as shown in FIG. 2 is similar to the edge connected package 2 as shown in FIG. 1 with the exception of the plurality of external leads 4' and 6' being of the gullwing type. Gullwing type external leads are typically attached to the PCB 12' by laser type soldering techniques. Both the edge connected packages 2 and 2' can provide twice as many external leads as current edge connected packages provide. Therefore, not only can larger memory arrays be accommodated but wider bit architectures may be provided for also. For example, large memory arrays having output buses of 4, 8, or 16 bits can realised using the arrangement described herein.

## Claims

1. A package enclosing at least one semiconductor device (8, 10) comprising

   an enclosure (2) enclosing said semiconductor device and having six generally rectangular faces, two of which have relatively large areas and the rest of which have relatively small areas and form edge faces, and

   a plurality of connecting leads (4, 6) connected to said semiconductor device and extending side by side generally in a line from one of said edge faces,

   characterised in that

   adjacent ones of said connecting leads project from said edge face in opposite directions.

2. A package as claimed in Claim 1 characterised in that each connecting lead (4, 6) is spaced from each adjacent lead by a distance of the order of 25 mils (0.625 mm).

3. A package as claimed in either of the preceding claims characterised in that at least one semiconductor device is attached to one of the relatively large area faces and at least one semiconductor device is attached to the other of the relatively large area faces.

4. A package as claimed in any one of the preceding claims characterised in that each of said connecting leads is of the SOJ type.

5. A package as claimed in any one of the preceding claims 1, 2 or 3 characterised in that each of said connecting leads is of the gull wing type.

FIG-1

FIG-2

European
Patent Office

EUROPEAN SEARCH
REPORT

Application Number

EP 91 30 6984

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | PATENT ABSTRACTS OF JAPAN vol. 12, no. 221 (E-625)(3068) 23 June 1988, & JP-A-63 016650 (NEC CORP) 23 January 1988, * the whole document * | 1,5,3,4 | H 01 L 23/495 |
| | − − − | | |
| X | PATENT ABSTRACTS OF JAPAN vol. 11, no. 359 (E-559)(2806) 21 November 1987, & JP-A-62 136060 (MITSUBISHI ELECTRIC CORP) 19 June 1987, * the whole document * | 1,5 | |
| | − − − | | |
| Y | PATENT ABSTRACTS OF JAPAN vol. 9, no. 147 (E-323)(1870) 21 June 1985, & JP-A-60 028256 (FUJITSU) 13 February 1985, * the whole document * | 3,4 | |
| | − − − | | |
| P,X | US-A-4 967 262   (W.M.FARNSWORTH) * column 3, lines 15 - 41; figures 1-3 * | 1,5 | |
| | − − − − − | | |

TECHNICAL FIELDS
SEARCHED (Int. Cl.5)

H 01 L

The present search report has been drawn up for all claims

| Place of search | Date of completion of search | Examiner |
|---|---|---|
| Berlin | 21 October 91 | LE MINH I |

CATEGORY OF CITED DOCUMENTS

X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

               

& : member of the same patent family, corresponding
document